# EUROPÄISCHE PATENTANMELDUNG

(11) **EP 2 578 635 A1**
(43) Veröffentlichungstag der Anmeldung: **10.04.2013**
(21) Anmeldenummer: 11184317.3
(22) Anmeldetag: 07.10.2011
(51) Int. Cl.: C08L 69/00

(54) **Polycarbonatzusammensetzungen mit guter Metallisierbarkeit**

(71) Anmelder: Bayer MaterialScience AG, 51373 Leverkusen (DE)
(72) Erfinder: Meyer, Alexander, 51368 Leverkusen (DE); Oser, Rafael, 51368 Leverkusen (DE)
(74) Vertreter: BIP Patents

(57) **Zusammenfassung**

Die Erfindung betrifft Blends aus speziellen Copolycarbonaten und speziellen Polyetherimiden oder speziellen Polyarylsulfonen mit guter Metallisierbarkeit sowie Zusammensetzungen aus diesen Copolycarbonat-Blends gegebenenfalls mit Additiven ausgewählt aus der Gruppe der Thermostabilisatoren und Entformungsmitteln, deren Verwendung zur Herstellung von Formteilen und daraus erhältliche Formteile. Desweiteren betrifft die Erfindung mehrschichtige Erzeugnisse umfassend ein Substrat enthaltend die erfindungsgemäßen Zusammensetzungen, die mindestens auf einer Seite wenigstens eine weitere Schicht aufweisen, bevorzugt eine Metallschicht, sowie Herfahren zur Herstellung solcher Erzeugnisse.

## Beschreibung

Die Erfindung betrifft Blends aus speziellen Copolycarbonaten und speziellen Polyetherimiden oder speziellen Polyarylsulfonen mit guter Metallisierbarkeit sowie Zusammensetzungen aus diesen Copolycarbonat-Blends gegebenenfalls mit Additiven ausgewählt aus der Gruppe der Thermostabilisatoren und Entformungsmitteln, deren Verwendung zur Herstellung von Formteilen und daraus erhältliche Formteile. Desweiteren betrifft die Erfindung mehrschichtige Erzeugnisse umfassend ein Substrat enthaltend die erfindungsgemäßen Zusammensetzungen, die mindestens auf einer Seite wenigstens eine weitere Schicht aufweisen, bevorzugt eine Metallschicht, sowie Herfahren zur Herstellung solcher Erzeugnisse.

Polycarbonate werden aufgrund ihrer hohen Wärmeformbeständigkeit u. a. in Bereichen eingesetzt, in denen mit einer erhöhten Temperaturbelastung zu rechnen ist. Mit speziellen Copolycarbonaten (wie z.B. bei einem Copolycarbonat basierend auf Bisphenol A und Bisphenol TMC (1,1-Bis-(4-hydroxyphenyl)-3,3,5-trimethylcyclohexan)) gelingt es, die Wärmeformbeständigkeit weiter zu erhöhen. Diese Polycarbonate eignen sich daher auch zur Herstellung von Linsen, Reflektoren, Lampenabdeckungen und -gehäusen etc., die einer höheren Temperaturbelastung ausgesetzt sind. Bei diesen Anwendungen sind praktisch immer erhöhte thermische Eigenschaften wie hohe Vicat-Erweichungstemperatur (Wärmeformbeständigkeit) bzw. hohe Glastemperatur in Kombination mit ausreichenden mechanischen Eigenschaften zwingend gefordert.

Polycarbonate aus Bisphenol A und Bisphenol TMC sind unter dem Handelsnamen Apec® von Bayer Materialscience AG kommerziell erhältlich.

Copolycarbonate basierend auf Cycloalkylidendiphenolen sind bekannt und verschiedenen Publikationen beschrieben worden.

So beschreiben die DE 3 903 103 A1, EP 414 083 A2 und die EP 359 953 A1 die Herstellung und Verwendung von Polycarbonaten auf Basis von Cycloalkylidendiphenolen.

**Auch eine Reihe von Zusammensetzungen enthaltend Copolycarbonate mit** Cycloalkylidendiphenolen und verschiedene weitere polymere Komponenten sind beschrieben worden.

So beschreibt die EP 362 646 A2 Blends aus Copolycarbonate mit Cycloalkylidendiphenolen und Kautschuken.

Die EP 401 629 A2 beschreibt hochtemperaturstabile Blends aus Copolycarbonaten enthaltend Cycloalkylidenbisphenolen und ABS-Polymere.

Die EP 410 239 A1 beschreibt Mischungen aus Copolycarbonaten enthaltend Cycloalkylidendiphenole und Polyester.

In DE 3 933 544 A1 werden werden Blends aus Cycloalkylidendiphenol-basierten Polycarbonaten, Polyamiden und Elastomeren beschrieben.

Keine dieser Anmeldungen beschreibt verbesserte optische Eigenschaften an metallisierten Formkörpern bei Temperaturen oberhalb 160°C. Keine Publikation beschreibt Blends aus Cycloalkylidendiphenol-basierten Copolycarbonaten und Polyetherimiden oder speziellen Polyarylethersulfon oder Polyarylsulfon. Aus dem bisherigen Stand der Technik ist nicht ersichtlich, wie das oben beschriebene Problem zu lösen ist.

In US 6,883,938 B1 werden Reflektoren oder metallisierte Formkörper aus Substratmaterialien, welche Norbomen-Derivate enthalten beschrieben. Diese Reflektoren basieren nicht auf Basis von Cycloalkylidendiphenol-abgeleiteten Polycarbonaten. Diese Patentschrift gibt keinen Hinweis zur Lösung der gestellten Aufgabe.

In US 7,128,959 B2 werden metallisierte Formkörper beschrieben. Als Substratmaterial können dabei Polycarbonate Polysulfone oder Polyetherimide bzw. deren Mischungen eingesetzt werden. Um eine gute Metallisierung zu gewährleisten, muss auf das jeweilige Substrat vor der Metallisierung eine Basisschicht aufgetragen werden. Mit dem Auftrag einer Basisschicht lässt sich das hier beschriebene Problem nicht lösen. Bei der in der vorliegenden Erfindung beschriebenen Zusammensetzung ist der Auftrag einer Basisschicht nicht nötig.

Neben einer guten Verarbeitbarkeit und guten mechanischen Eigenschaften müssen diese Materialien auch weiteren Anforderungen wie einer guten Oberflächenqualität im resultierenden Spritzgussteil / Extrudat sowie einer guten Metallhaftung genügen.

Je nach eingesetzten Bisphenolen und geeigneter Einstellung des Molekulargewichts der Homo-und Copolycarbonate lassen sich die Wärmeformbeständigkeit und die mechanischen Eigenschaften in einem weiten Bereich variieren. Jedoch besteht für bestimmte Anwendungen nach wie vor der Bedarf einer weiter verbesserten Metallhaftung. So ist gerade im Bereich von Reflektoren eine gute Metallhaftung unabdingbar.

Wie oben beschrieben müssen die entsprechenden metallisierten Teile eine hohe Temperaturbeständigkeit aufweisen. So dürfen weder die mechanischen Eigenschaften noch die optischen Eigenschaften wie z.B. die Qualität der Metalloberfläche abnehmen. Es zeigte sich jedoch, dass metallisierte Formkörper aus speziellen Copolycarbonaten, welche Vicat-Erweichungstemperaturen von mehr als 160 °C, insbesondere mehr als 170 °C, aufweisen und welche u.a. 1,1-Bis-(4-hydroxyphenyl)-cyclohexan-Derivate enthalten, für spezielle Anwendungen eine oftmals nicht ausreichende optische Qualität bei sehr hohen Temperaturen aufweisen. So neigen derartige Formkörper, die unter speziellen Bedingungen, insbesondere unter PlasmaBedingungen, metallisiert und vorbehandelt wurden, zu Blasenbildung (Blasen- und Rissbildung der Beschichtung) bei hohen Temperaturen (insbesondere bei Temperaturen oder Temperaturspitzen von größer 170 °C). Dies kann zum Ausfall des entsprechenden Formköpers in der jeweiligen Anwendung führen. Durch die Blasenbildung verliert die Metalloberfläche ihr einheitliches Aussehen - ferner wird die Reflexion von Licht negativ beeinflusst.

Dieses Phänomen tritt überraschenderweise insbesondere dann verstärkt auf, wenn die oben genannten Copolycarbonate bestimmte Additive wie Titandioxid enthalten. Titandioxid wird jedoch dazu verwendet, um in resultierenden Formkörpern eine bestimmte Farbe einzustellen und ist daher ein wichtiges Bestandteil der Zusammensetzungen. Der Verzicht auf Titandioxid führt dazu, andere Pigmente und Verbindungen einzusetzen, die deutlich teurer sind und dadurch das Verfahren weniger ökonimisch machen, und / oder in der Alterung instabiel sind. Neben Titandioxid können weitere Farbmittel oder Pigmente wie Ruß eingesetzt werden. Eine häufig gewünschte Farbe im Elektronikbereich ist z.B. Grau (wie das sogenannte "Elektrograu").

Es bestand daher die Aufgabe, weiß- bzw grau-eingefärbte Polycarbonatzusammensetzungen mit Vicat-Erweichungstemperaturen von größer 160 °C, bevorzugt größer 170 °C zur Verfügung zu stellen, welche Copolycarbonate auf Basis von 1,1-Bis-(4-hydroxyphenyl)-cyclohexan-Derivaten enthalten und die sich leicht metallisieren lassen und ferner zu defektfreien Metalloberflächen am entsprechend metallisierten Formkörper führen.

Ferner bestand die Aufgabe darin, weiß bzw. grau eingefärbte Produkte zu ermöglichen. Dabei sollen diese Produkte eine überragende Metallisierbarkeit aufweisen.

Ferner war die Aufgabe einen Mehrschichtkörper bestehend aus einem Substratmaterial enthaltend zumindest zu 60 Gew.-%, bezogen auf die Gesamtmenge der Bisphenol-Derivaten, Copolycarbonat auf Basis von 1,1-Bis-(4-hydroxyphenyl)-cyclohexan-Derivaten sowie mindestens einer Metallschicht zu entwickeln, welche eine hervorragende Oberflächenqualität aufweisen und die Oberflächenqualität auch unter hohen Temperaturen beibehalten.

Überraschenderweise konnte die Aufgabe durch bestimmte Polycarbonatmischungen die spezielle Polyetherimide und / oder spezielle Polyarylsulfone enthalten, gelöst werden. Metallisierte Formkörper aus diesen Zusammensetzungen erhalten eine defektfreie Metalloberfläche auch bei sehr hohen Gebrauchstemperaturen von 160 - 210 °C.

Die Aufgabe wurde erfindungsgemäß durch eine Polymerzusammensetzung gelöst, enthaltend
A) (nachfolgend auch als Komponente A bezeichnet) 60 Gew.-% bis 99 Gew.-% bevorzugt 65 Gew.-% bis 98 Gew.-% und insbesondere bevorzugt 70 Gew.-% bis 95 Gew.-% (bezogen auf die Summe der Gewichtsteile der Komponenten A+B) aus einem oder mehreren Copolycarbonaten mit einer Vicat-Erweichungstemperaturen (gemessen nach DIN ISO 306) von größer als 160 °C, bevorzugt von größer als 165 °C, insbesondere bevorzugt größer als 170 °C enthaltend als Kettenabbrecher (Endgruppe) eine Struktureinheit der Formel (1) 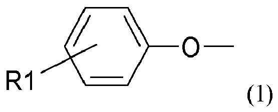 in der
   R1 für Wasserstoff oder C₁-C₁₈-Alkyl stehen; ganz besonders bevorzugt sind als Kettenabbrecher Phenol oder tert.-Butylphenol oder n-Butylphenol, insbesondere Phenol und p-tert. Butylphenol,
   und
   mindestens ein Diphenolbaustein der Formel (2) enthält, 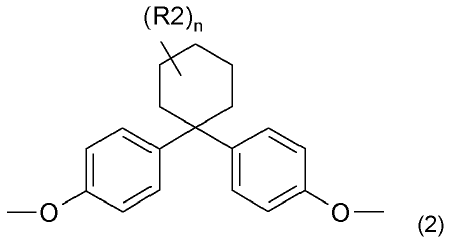 in der
   R2 für C₁-C₄-Alkyl, bevorzugt Methyl-, Ethyl-, Propyl-, Isopropyl- und Butylsowie Isobutylreste, besonders bevorzugt Methyl,
   n für 0, 1, 2 oder 3, bevorzugt 2 oder 3 stehen.
B) (nachfolgend auch als Komponente B bezeichnet) 1 Gew.-% - 40 Gew.-%, bevorzugt 2 Gew.-% - 35 Gew.-% und insbesondere bevorzugt 5 Gew.-% - 30 Gew.-% (bezogen auf die Summe der Gewichtsteile der Komponenten A+B) aus einem oder mehreren speziellen Polyarylsulfonen und / oder speziellen Polyetherimiden, welche die allgemeine Formel (I) , (II) oder (III) als Wiederholungseinheit aufweisen:

   -O-A-SO₂-A- (I)

   -O-A-SO₂-A-O-B- (II)

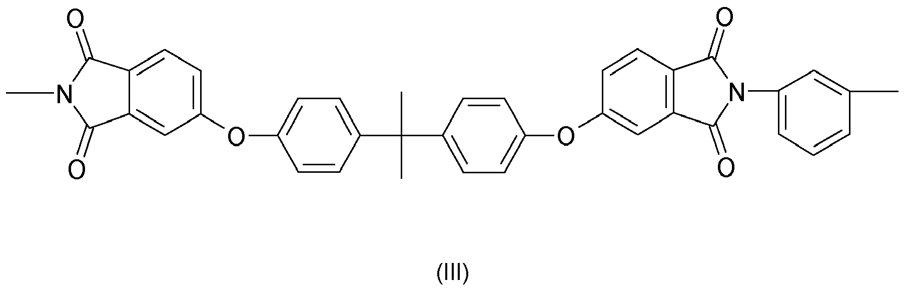

   worin A und B für gegebenenfalls substituierte aromatische Reste stehen können. Die aromatischen Reste bestehen aus 6 bis 40 C-Atomen, bevorzugt aus 6 - 21 C-Atomen, die einen oder mehrere gegebenenfalls kondensierte aromatische Kerne enthalten, wobei die Kerne gegebenenfalls Heteroatome enthalten können. Diese aromatischen Kerne können gegebenenfalls mit linearen oder verzweigten oder cycloaliphatischen C₁- bis C₁₅- Resten oder Halogenatomen substituiert sein. Die aromatischen Kerne können über Kohlenstoffbindungen oder über Heteroatome als Brückenglied verbunden sein.
C) optional 0,0 Gew.-% bis 1,0 Gew.-%, bevorzugt 0,01 Gew.-% bis 0,50 Gew.-%, besonders bevorzugt 0,01 Gew.-% bis 0,40 Gew.-% (bezogen auf die Summe der Gewichtsteile der Komponenten A+B = 100) ein oder mehrere Entformers (nachfolgend auch als Komponente C bezeichnet)
D) optional 0,00 Gew.-%- 0,20 Gew.-%, bevorzugt 0,01 Gew.-% - 0,10 Gew.-% (bezogen auf die Summe der Gewichtsteile der Komponenten A+B = 100), ein oder mehrere Thermo- bzw. Verarbeitungsstabilisatoren, bevorzugt ausgewählt aus der Gruppe der Phosphine, Phosphite und phenolische Antioxidantien sowie deren Mischungen (nachfolgend auch als Komponente D bezeichnet)
E) optional 0,00 Gew.-% bis 0,05 Gew.-%, bevorzugt 0,01 Gew.-% bis 0,04 Gew.-% (bezogen auf die Summe der Gewichtsteile der Komponenten A+B = 100) ein oder mehrere Farbmittel (nachfolgend auch als Komponente E bezeichnet)
F) optional 0,0 Gew.-% bis 5 Gew.-%, bevorzugt 0,01 Gew.-% bis 1,00 Gew.-% (bezogen auf die Summe der Gewichtsteile der Komponenten A+B = 100) ein oder mehrere Additive (nachfolgend auch als Komponente F bezeichnet).

### Komponente A

Bevorzugte Diphenolbausteine der Formel (2) sind z.B. von 1,1-Bis-(4-hydroxyphenyl)-cyclohexan und 1,1-Bis-(4-hydroxyphenyl)-3,3,5-trimethylcyclohexan, bevorzugt 1,1-Bis-(4-hydroxyphenyl)-3,3,5-trimethylcyclohexan abgeleitet.

Dabei sind Copolycarbonate bevorzugt, die 20 Gew.-% bis 98 Gew.-% insbesondere bevorzugt 25 Gew.-% bis 95 Gew.-% Diphenolbaustein der Formel (2) enthalten.

Ausser den Diphenolen der Formel (2) sind für die Herstellung der Copolycarbonate geeignete Dihydroxyarylverbindungen solche der Formel (3)

HO-Z-OH (3)

in welcher
- Z: ein aromatischer Rest mit 6 bis 30 C-Atomen ist, der einen oder mehrere aromatische Kerne enthalten kann, substituiert sein kann und aliphatische oder cycloaliphatische Reste bzw. Alkylaryle oder Heteroatome als Brückenglieder enthalten kann.

Bevorzugt steht Z in Formel (3) für einen Rest der Formel (3a) 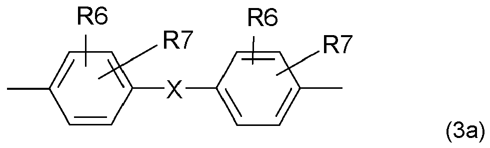 in der
R6 und R7 unabhängig voneinander für H, C₁-C₁₈-Alkyl-, C₁-C₁₈-Alkoxy, Halogen wie Cl oder Br oder für jeweils gegebenenfalls substituiertes Aryl- oder Aralkyl, bevorzugt für H oder C₁-C₁₂-Alkyl, besonders bevorzugt für H oder C₁-C₈-Alkyl und ganz besonders bevorzugt für H oder Methyl stehen, und
X für -CO- , -O- , -S-, C₁- bis C₆-Alkylen, C₂- bis C₅-Alkyliden oder für C₆- bis C₁₂-Arylen, welches gegebenenfalls mit weiteren Heteroatome enthaltenden aromatischen Ringen kondensiert sein kann, steht.

Bevorzugt steht X für, C₁ bis C₅-Alkylen, C₂ bis C₅-Alkyliden, -O- , -SO- , -CO- , -S- , - SO₂-, Isopropyliden oder Sauerstoff, insbesondere für Isopropyliden.

Für die Herstellung der erfindungsgemäss zu verwendenden Copolycarbonate geeignete Diphenole der Formel (3) sind beispielsweise Hydrochinon, Resorcin, Bis-(hydroxyphenyl)-alkane, Bis-(hydroxyphenyl)-sulfide, Bis-(hydroxyphenyl)-ether, Bis-(hydroxyphenyl)-ketone, Bis-(hydroxyphenyl)-sulfone, Bis-(hydroxyphenyl)-sulfoxide, [alpha],[alpha]'-Bis-(hydroxyphenyl)-diisopropylbenzole, sowie deren alkylierte, kernalkylierte und kernhalogenierte Verbindungen.

Ferner bevorzugte Diphenole der Formel (3) sind 4,4'-Dihydroxydiphenyl, 2,2-Bis-(4-hydroxyphenyl)-1-phenyl-propan, 1,1-Bis-(4-hydroxyphenyl)-phenyl-ethan, 2,2-Bis-(4-hydroxyphenyl)propan, 2,2-Bis-(3-methyl, 4-hydroxyphenyl)-propan, 2,4-Bis-(4-hydroxyphenyl)-2-methylbutan, 1,3-Bis-[2-(4-hydroxyphenyl)-2-propyl]benzol (Bisphenol M), 2,2-Bis-(3-methyl-4-hydroxyphenyl)-propan, Bis-(3,5-dimethyl-4-hydroxyphenyl)-methan, 2,2-Bis-(3,5-dimethyl-4-hydroxyphenyl)-propan, Bis-(3,5-dimethyl-4-hydroxyphenyl)-sulfon, 2,4-Bis-(3,5-dimethyl-4-hydroxyphenyl)-2-methylbutan, 1,3-Bis-[2-(3,5-dimethyl-4-hydroxyphenyl)-2-propyl]-benzol.

Besonders bevorzugte Diphenole der Formel (3) sind 2,2-Bis-(4-hydroxyphenyl)-propan (BPA), und 2,2-Bis-(3-methyl, 4-hydroxyphenyl)-propan.

Besonders bevorzugt sind Copolycarbonate aus Bisphenol A und Bisphenol TMC.

Diese und weitere geeignete Diphenole sind kommerziell erhältlich und z. B. in "H. Schnell, Chemistry and Physics of Polycarbonates, Interscience Publishers, New York 1964, S. 28 ff; S. 102 ff" , und in "D. G. Legrand, J. T. Bendler, Handbook of Polycarbonate Science and Technology, Marcel Dekker New York 2000, S. 72 ff." beschrieben.

Die thermoplastischen Copolycarbonate haben Molekulargewichte Mw (Gewichtsmittel Mw, ermittelt durch Gelpermeationschromatographie GPC Messung) von 12 000 bis 120 000, vorzugsweise von 15 000 bis 80 000, insbesondere von 18 000 bis 60 000, ganz besonders bevorzugt von 18 000 bis 40 000 g/mol. Molekulargewichte lassen sich auch durch die Zahlenmittel Mn angeben, welche ebenfalls nach vorheriger Eichung auf Polycarbonat mittels GPC bestimmt werden.

### Komponente B

A kann z.B. für Phenylen, Alkylphenylen, Alkoxyphenylen bzw. für entsprechende Chlor- oder Fluor-substituierte Derivate stehen, bevorzugt für unsubstituierte Phenylenreste.

B steht bevorzugt für von Bisphenolen abgeleitete Reste, denen die allgemeine Formel (IV) oder (V) zugrunde liegt 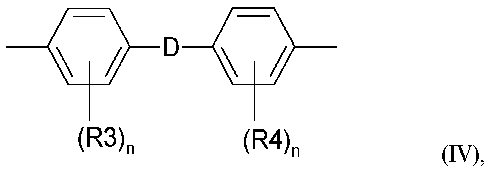 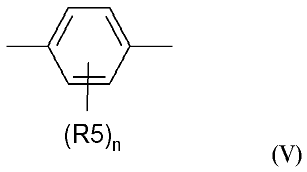 wobei R3, R4 und R5 jeweils unabhängig voneinander, gleich oder verschieden für Wasserstoff, Halogen, C₁-C₆-Alkyl, oder C₁-C₆-Alkoxy-, vorzugsweise für Wasserstoff, Fluor, Chlor, oder Brom steht,
n für eine ganze Zahl 1 - 4 vorzugsweise 1,2,3, insbesondere 1 oder 2 steht,
D für eine chemische Bindung -CO- , -O- , -S- , vorzugsweise für eine Einfachbindung steht.

Bevorzugt sind dabei Polymere der Formel (I) wobei A für einen Phenylenrest steht. Diese sogenannten Polyethersulfone (CAS: 25608-63-3) sind z.B. unter dem Handelsnamen Ultrason® E 2010 bei der BASF SE (67056 Ludwigshafen, Deutschland) erhältlich.

Weiterhin bevorzugt sind Polymere der Formel (II) wobei A für einen Phenylenrest und B für einen Phenylenrest steht.

Insbesondere bevorzugt sind Polymere der Formel (II) wobei A für einen Phenylenrest und B für einen Biphenylenrest steht. Diese sogenannten Polyphenylsulfone (CAS 25608-64-4) sind unter dem Handelsnamen Radel® R (z.B. Radel® R 5900) bei Solvay Advanced Polymers oder Ultrason® P bei BASF SE (67056 Ludwigshafen, Deutschland) erhältlich.

Weiterhin bevorzugt sind Polymere der Formel (III). Diese Polymere sind z.B. unter dem Handelsnamen Ultem® (CAS 61128-46-9) von der Firma Sabic Innovative Plastics erhältlich.

Auch Mischungen der oben genannten Polymere sind möglich.

Die Polymerzusammensetzung kann Additive enthalten.

Als Entformungsmitttel (Komponente C) eignen sich bevorzugt Pentaerythrittetrastearat, Glycerinmonostearat, Stearylstearat oder Propoandiolmono- bzw. distearat. Sie werden allein oder im Gemisch eingesetzt.

Als Thermostabilisator (Komponente D) eignen sich bevorzugt Tris-(2,4-di-tert-butylphenyl)phosphit (Irgafos 168), Tetrakis(2,4-di-tert.-butylphenyl)[1,1biphenyl]-4,4'-diylbisphosphonit, Trisoctylphosphat, Octadecyl-3-(3,5-di-tert butyl-4-hydroxyphenyl)propionat (Irganox 1076), Bis(2,4-dicumylphenyl)pentaerythritoldiphosphit (Doverphos S-9228), Bis(2,6-di-tert.butyl-4-methylphenyl)pentaerythritoldiphosphit (ADK STAB PEP-36) oder Triphenylphosphin. Sie werden allein oder im Gemisch (z. B. Irganox B900 oder Doverphos S-92228 mit Irganox B900 bzw. Irganox 1076) eingesetzt.

Desweiteren können Farbmittel (Komponente E), wie organische Farbstoffe oder Pigmente oder anorganische Pigmente, einzeln, im Gemisch oder auch in Kombination mit Stabilisatoren, oder organische oder anorganische Streupigmente zugesetzt werden. Dabei ist die erfindungsgemäße Zusammensetzung bevorzugt frei von Titandioxid.

Als UV-Stabilisatoren (Komponente F) eignen sich bevorzugt 2-(2'-Hydroxyphenyl)benzotriazole, 2-Hydroxybenzophenone, Ester von substituierten und unsubstituierten Benzoesäuren, Acrylate, sterisch gehinderte Amine, Oxamide, 2-(2-Hydroxyphenyl)-1,3,5-triazine, besonders bevorzugt sind substituierte Benztriazole wie beispielsweise Tinuvin 360, Tinuvin 350, Tinuvin 234, Tinuvin 329 oder UV CGX 006 (Ciba).

Die Zusammensetzung kann zudem weitere handelsübliche Polymeradditive (Komponente F) wie Flammschutzmittel, Flammschutzsynergisten, Antidrippingmittel (beispielsweise Verbindungen der Substanzklassen der fluorierten Polyolefine, der Silikone sowie Aramidfasern), Nukleiermittel, Antistatika (beispielsweise Leitrusse, Carbonfasern, Carbon Nanotubes sowie organische Antistatika wie Polyalkylenether, Alkylsulfonate oder Polyamid-haltige Polymere) in solchen Mengen enthalten, die die mechanischen Eigenschaften der Zusammensetzung nicht insoweit schädigen, dass das Zieleigenschaftsprofil nicht mehr erfüllt wird.

Geeignete Additive sind beispielsweise beschrieben in "Additives for Plastics Handbook, John Murphy, Elsevier, Oxford 1999", im "Plastics Additives Handbook, Hans Zweifel, Hanser, München 2001" oder in WO 99/55772 , S. 15-25.

Gegenstand der vorliegenden Anmeldung sind weiterhin Mehrschichtsysteme bestehen aus einer Schicht i) bestehend aus einem Substratmaterial aus einer Mischung aus Komponente A) und B) sowie optional eine oder mehrerer der Komponenten C) bis E),
sowie mindestens einer Schicht ii) gebildet aus wenigstens einem Metall und / oder wenigstens einer Metallverbindung, wobei das Metall bevorzugt aus Aluminium, Silber, Chrom, Titan, Palladium, bevorzugt aus Aluminium besteht. Auch Legierungen enthaltend diese Metalle sind möglich. Des weiteren sind auch Metalloxide und - nitride wie z.B. CrOₓ oder TiNₓ eingeschlossen.

Dabei weist i) bevorzugt eine Schichtdicke von 0,05 mm bis 6,00 mm, besonders bevorzugt 0,1 mm bis 5,0 mm und insbesondere bevorzugt 0,5 mm bis 4,0 mm auf.

Die Schicht ii) weist bevorzugt eine Dicke von 10 nm- 1000 nm insbesondere bevorzugt 30 nm - 500 nm und ganz besonders bevorzugt 40 nm - 300 nm auf.

In einer bevorzugten Ausführungsform trägt die Schicht ii) eine Schutzschicht iii) enthaltend plasmapolymerisierten Siloxanen der Dicke 5 nm - 200 nm, bevorzugt 15 nm - 150 nm ganz besonders bevorzugt 20 nm - 100 nm.

In einer weiteren bevorzugten Ausführungsform kann weiterhin eine Schicht iv) enthalten sein, die eine Kondensatbildung auf der Oberfläche verhindert. Diese Schicht hat eine Dicke von 1 - 50 nm. Die Ausgangstoffe zur Herstellung dieser Schicht sowie das Verfahren zum Auftrag sind in EP 857 518 A angegeben.

Vollkommen überraschend war die Tatsache, dass andere - strukturell ähnliche - Zusammensetzungen zu sehr schlechten Oberflächeneigenschaften führen. So konnte z.B. im Rahmen der Erfindung gezeigt werden, dass Mehrschichtkörper aus Polymeren der Komponente A) mit herkömmlichen Polysulfonen (CAS: 25135-51-7) enthaltend eine Metallschicht zu Blasenbildung bei hohen Temperaturen neigen. Dies war in Anbetracht der sehr ähnlichen Polymerstrukturen höchst überraschend und konnte nicht vorhergesehen werden.

Die aus den erfindungsgemässen Copolycarbonaten und Copolycarbonat-zusammensetzungen hergestellten Spritzgussteile oder Extrudate weisen signifikant verbesserte thermische Eigenschaften (Glastemperatur sowie Vicat-Temperatur) in Verbindung mit einer guten Metallisierbarkeit auf. Die Oberflächenqualität bei auch bei hoher Temperaturbelastung erhalten. Dabei bleiben die mechanischen, thermischen und rheologischen Eigenschaften gegenüber den Standard-Copolycarbonaten (wie z.B. Apec) fast unverändert.

Die erfindungsgemässen thermoplastischen Formmassen werden hergestellt, indem man die jeweiligen Bestandteile in bekannter Weise vermischt und bei Temperaturen von 200 °C bis 380 °C, bevorzugt bei 240 bis 350 °C, in üblichen Aggregaten wie Innenknetern, Extrudern und Doppelwellenschnecken schmelzcompoundiert und schmelzextrudiert.

Die Polymerzusammensetzungen werden insbesondere zur Herstellung von Bauteilen verwendet, bei denen optische, thermische und mechanische Eigenschaften genutzt werden, wie beispielsweise Gehäuse, Gegenstände im E/E-Bereich, wie Stecker, Schalter, Platten, Lampenhalterungen, - abdeckungen, Lampenfassungen und -abdeckungen, Reflektoren und andere Anwendungen.

Die Extrudate und Formkörper bzw. Formteile aus den erfindungsgemässen Polymeren sind ebenfalls Gegenstand der vorliegenden Anmeldung.

Die Copolycarbonate der Komponente A) werden nach einem kontinuierlichen Phasengrenzflächenverfahren hergestellt. Die Herstellung der erfindungsgemäss zu verwendenden Copolycarbonate erfolgt prinzipiell in bekannter Weise aus Diphenolen, Kohlensäurederivaten und gegebenenfalls Verzweigern.

Allgemein ist das Verfahren zur Polycarbonatsynthese bekannt und in zahlreichen Publikationen beschrieben. EP 517 044 A, WO 2006/072344 sowie EP 1 609 818 A, und dort zitierte Dokumente beschreiben beispielsweise das Phasengrenzflächen und das Schmelzeverfahren zur Herstellung von Polycarbonat.

Beim Konti-Verfahren zur Herstellung von aromatischen Copolycarbonaten wird nach dem sogenannten Phasengrenzflächenverfahren gearbeitet. Dabei erfolgt die Phosgenierung eines in wässrigalkalischer Lösung (oder Suspension) vorgelegten Dinatriumsalzes eines Gemisches verschiedener Bisphenole in Gegenwart eines inerten organischen Lösungsmittels bzw. bevorzugt eines Lösungsmittelgemisches, welches eine zweite Phase ausbildet. Die entstehenden, hauptsächlich in der organischen Phase vorliegenden Oligocarbonate werden mit Hilfe geeigneter Katalysatoren zu, in der organischen Phase gelösten, Copolycarbonaten mit dem gewünschten Molekulargewicht aufkondensiert. Die organische Phase wird schliesslich abgetrennt und das Copolycarbonat durch verschiedene Aufarbeitungsschritte, bevorzugt durch Ausdampfextruder bzw. Strangverdampfer, daraus isoliert.

Die verwendeten Diphenole, wie auch alle anderen der Synthese zugesetzten Chemikalien und Hilfsstoffe können mit den aus ihrer eigenen Synthese, Handhabung und Lagerung stammenden Verunreinigungen kontaminiert sein. Es ist jedoch wünschenswert, mit möglichst reinen Rohstoffen zu arbeiten.

Die Synthese von Copolycarbonaten aus Bisphenolen und Phosgen im alkalischen Milieu ist eine exotherme Reaktion und wird in einem Temperaturbereich von -5 °C bis 100 °C, bevorzugt 15 °C bis 80 °C, ganz besonders bevorzugt von 25 °C bis 65 °C durchgeführt, wobei je nach Lösungsmittel oder Lösungsmittelgemisch gegebenenfalls unter Überdruck gearbeitet werden muss.

Die Durchführung der Copolycarbonatsynthese erfolgt kontinuierlich. Die Reaktion kann in daher in Umpumpreaktoren, Rohrreaktoren, oder Rührkesselkaskaden oder deren Kombinationen erfolgen, wobei durch Verwendung der bereits erwähnten Mischorgane sicherzustellen ist, dass wässrige und organische Phase sich möglichst erst dann entmischen, wenn das Synthesegemisch ausreagiert hat, d. h. kein verseifbares Chlor von Phosgen oder Chlorkohlensäureestern mehr enthält.

Die zur Regelung des Molekulargewichtes benötigten monofunktionellen Kettenabbrecher der Formel 1 bzw. Gemische hieraus, werden als solche oder in Form ihrer Chlorkohlensäureester, entweder mit dem Bisphenolat bzw. den Bisphenolaten der Reaktion zugeführt oder aber zu jedem beliebigen Zeitpunkt der Synthese zugesetzt, solange im Reaktionsgemisch noch Phosgen oder Chlorkohlensäureendgruppen vorhanden sind bzw. im Falle der Säurechloride und Chlorkohlensäureester als Kettenabbrecher solange genügend phenolische Endgruppen des sich bildenden Polymers zur Verfügung stehen. Vorzugsweise werden der oder die Kettenabbrecher jedoch nach der Phosgenierung an einem Ort oder zu einem Zeitpunkt zugegeben, wenn kein Phosgen mehr vorliegt, aber der Katalysator noch nicht dosiert wurde, bzw. sie werden vor dem Katalysator, mit dem Katalysator zusammen oder parallel dazu dosiert.

Die Menge an einzusetzenden Kettenabrecher beträgt 0,5 Mol-% bis 10 Mol-%, bevorzugt 1 Mol-% bis 8 Mol-%, besonders bevorzugt 2 Mol-% bis 6 Mol-% bezogen auf Mole an jeweils eingesetzten Diphenolen. Die Zugabe der Kettenabbrecher kann vor, während oder nach der Phosgenierung erfolgen, bevorzugt als Lösung in einem Lösungsmittelgemisch aus Methylenchlorid und Chlorbenzol (8-15 Gew.%-ig).

Die in der Phasengrenzflächensynthese verwendeten Katalysatoren sind tert. Amine, insbesondere Triethylamin, Tributylamin, Trioctylamin, N-Ethylpiperidin, N-Methylpiperidin, N-i/n-Propylpiperidin, besonders bevorzugt Triethylamin und N-Ethylpiperidin. Die Katalysatoren können einzeln, im Gemisch oder auch neben- und nacheinander der Synthese zugesetzt werden, gegebenenfalls auch vor der Phosgenierung, bevorzugt sind jedoch Dosierungen nach der Phosgeneintragung. Die Dosierung des Katalysators oder der Katalysatoren kann in Substanz, in einem inerten Lösungsmittel, vorzugsweise dem der Polycarbonatsynthese, oder auch als wässrige Lösung, im Falle der tert. Amine dann als deren Ammoniumsalze mit Säuren, bevorzugt Mi neralsäuren, insbesondere Salzsäure, erfolgen. Bei Verwendung mehrerer Katalysatoren oder der Dosierung von Teilmengen der Katalysatorgesamtmenge können natürlich auch unterschiedliche Dosierungsweisen an verschiedenen Orten oder zu verschiedenen Zeiten vorgenommen werden. Die Gesamtmenge der verwendeten Katalysatoren liegt im Bereich von 0,001 bis 10 Mol-% bezogen auf Mole eingesetzte Bisphenole, bevorzugt von 0,01 bis 8 Mol-%, besonders bevorzugt von 0,05 bis 5 Mol-%.

Die organische, das Polymer enthaltende Phase muss nun von allen Kontaminationen alkalischer, ionischer oder katalytischer Art gereinigt werden. Die organische Phase enthält auch nach einem oder mehreren Absetzvorgängen, gegebenenfalls unterstützt durch Durchlaufe durch Absetzkessel, Rührkessel, Coalescer oder Separatoren bzw. Kombinationen aus diesen Massnahmen - wobei gegebenenfalls Wasser in jedem oder einigen Trennschritten unter Umständen unter Verwendung von aktiven oder passiven Mischorganen zudosiert werden kann - noch Anteile der wässrigen alkalischen Phase in feinen Tröpfchen sowie den Katalysator, in der Regel ein tert. Amin.

Nach der groben Abtrennung der alkalischen, wässrigen Phase wird die organische Phase ein oder mehrmals mit verdünnten Säuren, Mineral-, Carbon- Hydroxycarbon- und/oder Sulfonsäuren gewaschen. Bevorzugt sind wässrige Mineralsäuren insbesondere Salzsäure, phosphorige Säure und Phosphorsäure oder Mischungen dieser Säuren.

Zwischen diesen Waschschritten oder auch nach der Wäsche können gegebenenfalls Säuren, vorzugsweise gelöst im Lösungsmittel welches der Polymerlösung zugrunde liegt, zugegeben werden. Bevorzugt werden hier Chlorwasserstoffgas und Phosphorsäure oder phosphorige Säure verwendet, die gegebenenfalls auch als Mischungen eingesetzt werden können.

Die erfindungsgemäßen Mehrschichtkörper enthalten mindestens ein Substratmaterial enthaltend Komponente A) und Komponente B) sowie eine Metallschicht.
Der Auftrag von Metallen auf das Polymer kann über verschiedene Methoden wie z.B. durch Aufdampfen oder Sputtern geschehen. Die Verfahren sind näher beschrieben z.B. in "Vakuumbeschichtung Bd.1 bis 5", H. Frey, VDI-Verlag Düsseldorf 1995 oder "Oberflächen- und Dünnschicht-Technologie" Teil 1, R.A. Haefer, Springer Verlag 1987.

Bevorzugt erfolgt der Metallauftrag mittels DC-Magnetron-Sputtern. Um eine bessere Metallhaftung zu erreichen und um die Substratoberfläche zu reinigen, werden die Substrate normalerweise einer Plasmavorbehandlung unterzogen. Eine Plasmavorbehandlung kann u. U. die Oberflächeneigenschaften von Polymeren verändern. Diese Methoden sind z.B. bei Friedrich et al. in Metallized plastics 5&6: Fundamental and applied aspects und H. Grünwald et al. In Surface and Coatings Technology 111 (1999) 287-296 beschrieben.

In einer besonderen Ausführungsform ist auf der Metallschicht des Mehrschichtkörpers noch eine Schutzschicht, beispielsweise zum Korrosionsschutz aufgetragen. Die korrosionsmindernde Schutzschlicht kann in einem PECVD (plasma enhanced chemical vapour deposition) oder Plasmapolymerisationsprozess aufgebracht werden. Hierbei werden niedrigsiedende Precursoren haupsächlich auf siloxan Basis in ein Plasma verdampft und dadurch aktiviert, so dass sie einen Film bilden können. Typsiche Substanzen hierbei sind Hexamethyldisiloxan (HMDSO), Tetrametyldisiloxan, Decamethylcyclopentasiloxan, Octamethylcyclotetrasiloxan und Trimethoximethylsilan. Besonders bevorzugt ist HMDSO.

### Beispiele

Im Folgenden wird die Erfindung anhand von Ausführungsbeispielen näher beschrieben, wobei die hier beschriebenen Bestimmungsmethoden für alle korrespondierenden Größen in der vorliegenden Erfindung zur Anwendung kommen, sofern nichts Gegenteiliges beschrieben worden ist.

Die Bestimmung des Schmelzvolumenrate (MVR) erfolgt nach ISO 1133 unter den unten angegebenen Bedingungen.

### Messung der Wärmeformbeständigkeit über die Vicat-Erweichungstemperatur:

Die Vicat-Erweichungstemperatur nach DIN EN ISO 306 wird mit einer Nadel (mit kreisrunder Fläche von 1 mm²) gemessen. Diese ist mit einer Prüfkraft von 50 N (Prüfkraft B) belastet. Der oben genannte Probekörper wird einer definierten Heizrate von 120 K/h ausgesetzt. Die Vicattemperatur ist erreicht, wenn der Eindringkörper eine Eindringtiefe von 1 mm erreicht. Sie wird nach DIN ISO 306 gemessen.

### Materialien:

### Copolycarbonat Komponente A):

Typ 1 : Copolycarbonat enthaltend 85 Gew.-% 1,1-Bis-(4-hydroxyphenyl)-3,3,5-trimethylcyclohexan und 15 Gew.-% Bisphenol A mit Phenol als Kettenabbrecher und einem MVR von 5 cm³/(10 min) (330 °C; 2,16 kg) gemäß ISO 1133 sowie einer Vicat-Erweichungstemperatur von 218 °C (ISO 306; 50 N; 120 K/h).
Typ 2: Copolycarbonat enthaltend 85 Gew.-% 1,1-Bis-(4-hydroxyphenyl)-3,3,5-trimethylcyclohexan und 15 Gew.-% Bisphenol A mit Phenol als Kettenabbrecher und einem MVR von 5 cm³/(10 min) (330 °C; 2,16 kg) gemäß ISO 1133 wird mit 0,004 Gew.-% Ruß (Lampblack 101, Evonik Carbon Black GmbH, 60287 Frankfurt a. M., Deutschland, Color Index: 77262) und 0,1 Gew.-% Titandioxid (Kronos 2230; Kronos International Inc., 51373 Leverklusen, Deutschland) unter oben beschriebenen Bedingungen compoundiert. Das resultierende Material hat eine Vicat-Erweichungstemperatur von 213 °C (ISO 306; 50 N; 120 K/h).

### Komponente B)

Polyphenylensulfon der Formel (II): Radel R5900 NT (CAS 25608-64-4) der Solvay Advanced Polymers GmbH (Düsseldorf, Deutschland) mit einem MVR von 16,3 cm³/(10min) (360 °C; 10 kg) gemäß ISO 1133.

Polysulfon, welches nicht unter Formel (I) oder (II) fällt für Vergleichsbeispiel: Ultrason S 6010 (CAS: 25154-01-2) mit einem MVR von 30 cm³/(10min) (360 °C; 10 kg) gemäß ISO 1133

### Compoundierung

Die Compoundierung der Materialien erfolgte auf einem Zweiwellenextruder der Firma KraussMaffei Berstorff, TYP ZE25, bei einer Gehäusetemperatur von 320 °C bzw. einer Massetemperatur von ca. 340°C und einer Drehzahl von 110 Upm mit den in den Beispielen angegebenen Mengen an Komponenten.

### Herstellung der Prüfkörper:

Zur Untersuchung der Metallisierungseigenschaften wurden Spritzguss-Rechteckplatten mit den Maßen 150 x 105 x 3,2 mm mit Seitenanguss in optischer Qualität angefertigt. Die Massetemperatur betrug 300 - 330 °C und die Werkzeugtemperatur 100 °C. Das jeweilige Granulat wurde vor Verarbeitung für 5 Stunden im Vakuumtrockenschrank bei 120 °C getrocknet.

### Metallisierungsprozess:

Alle Platten wurden vor der Beschichtung für 21 Tage bei 50 % Luftfeuchtigkeit und 23 °C gelagert.
Die Beschichtungsanlage bestand aus einer Vakuumkammer bei der die Proben auf einem rotierenden Probenhalter positioniert wurden. Der Probenhalter rotierte mit ca. 20 U/min. Die Prüfkörper wurden, bevor sie in die Vakuumkammer eingebracht wurden, mit ionisierter Luft abgeblasen, um sie von Staub zu befreien. Danach wurde die Vakuumkammer mit den Prüfkörper auf einen Druck p ≤ 1 · 10-5 mbar evakuiert. Anschließend wurde Argon Gas bis zu einem Druck von 0,1mbar eingelassen und bei einer Leistung von 1000W für 2 min ein Plasma gezündet und die Proben diesem Plasma ausgesetzt (Plasmavorbehandlung). Als Plasmaquelle wurde eine Diodenanordung bestehend aus 2 parallelen Metallelektroden verwendet, die mit einer Wechselfrequenz von 50kHz und einer Spannung größer 1000V betrieben wurde. Danach wurden die Proben metallisiert. Dafür wurde Ar-Gas mit einem Druck von 5 · 10-3 mbar eingelassen. Mittels DC-Magnetron wurde eine Aluminium-Schicht von ca. 100 nm Dicke mit einer Leistungsdichte von 6,4 W/cm2 auf die Proben aufgebracht. Die Sputterzeit betrug 2,5 min. Danach wurde mittels Plasmapolymerisation eine Korrosionsschutzschicht aus HMDSO aufgebracht. Dazu wurde HMDSO verdampft und der Dampf in die Vakuumkammer eingelassen bis sich ein Druck von ca. 0,07 mbar ergab. Danach wurde ein Plasma mit der oben beschriebenen Diodenanordnung bei 1000W gezündet während 1 Minute die Korrosionschutzschicht aufgebracht.

### Test der Oberflächenqualität nach Wärmelagerung:

Der Test wird direkt nach der Metallisierung durchgeführt. Damit ist gemeint, dass die Platten nach Metallisierung innerhalb einer Stunde diesem Test unterworfen werden.
Die metallisierten Platten werden dabei in einer Klimakammer für 2-3 Stunden bei 45 °C und 100 % relativer Feuchte gelagert. Direkt nach der Klimalagerung werden die Platten für eine Stunde bei 195 °C in einem Ofen gelagert.
Danach wird die Metalloberfläche abgemustert.

### Visuelle Abmusterung:

Die Oberfläche wird auf blasenförmige Aufwerfungen, Eintrübung der Metallschicht sowie auf Irisierung untersucht. Platten die weder Irisierung noch Trübung, noch Blasen aufweisen werden als "sehr gut" gekennzeichnet.

### Beispiel 1 (Vergleichsbeispiel)

Copolycarbonat der Komponente A) Typ 1 wird wie oben beschrieben zu Formkörpern verarbeitet. Die Metallisierung erfolgt wie oben beschrieben.
Das Ergebnis der Wärmelagerung ist in Tabelle 1 aufgeführt.

### Beispiel 2 (erfindungsgemäß)

Copolycarbonat der Komponente A) Typ 1 wird mit 10 Gew.-% der Komponente B) Radel R5900 NT unter den oben beschriebenen Bedingungen compoundiert. Es werden die oben beschriebenen Prüfkörper hergestellt und metallisiert.
Das Ergebnis der Wärmelagerung ist in Tabelle 1 aufgeführt.

### Beispiel 3 (erfindungsgemäß)

Copolycarbonat der Komponente A) Typ 1 wird mit 15 Gew.-% der Komponente B) Radel R5900 NT unter den oben beschriebenen Bedingungen compoundiert. Es werden die oben beschriebenen Prüfkörper hergestellt und metallisiert.

Das Ergebnis der Wärmelagerung ist in Tabelle 1 aufgeführt.

### Beispiel 4 (Vergleichsbeispiel)

Copolycarbonat der Komponente A) Typ 1 wird mit 10 Gew.-% der Komponente B) Ultrason S 6010 unter den oben beschriebenen Bedingungen compoundiert. Es werden die oben beschriebenen Prüfkörper hergestellt und metallisiert.
Das Ergebnis der Wärmelagerung ist in Tabelle 1 aufgeführt.

### Beispiel 5 (Vergleichsbeispiel)

Copolycarbonat der Komponente A) Typ 2 wie oben beschrieben zu Formkörpern verarbeitet. und metallisiert.
Das Ergebnis der Wärmelagerung ist in Tabelle 1 aufgeführt. Tabelle 1 :

| Beispiel Nr. | Vicat [°C] | Farbe der unmetallisierten Platte | Visuelle Abmusterung der Oberflächenqualität (metallisierter Körper nach Thermolagerung) |
|---|---|---|---|
| 1 (Vergleich) | 218 | transparent | Stellenweise Blasen; Metallablösung |
| 2 (efindungsgemäß) | 218 | grau, intransparent | Sehr gut |
| 3 (efindungsgemäß) | 218 | grau, intransparent | Sehr gut |
| 4 (Vergleich) | 218 | grau, intransparent | Stellenweise Blasen; Metallablösung |
| 5 (Vergleich) | 213 | grau, intransparent | Vollflächig Blasen; Metallablösung |

Es zeigt sich, dass ein Copolycarbonat aus Beispiel 1 unter den gegebenen Testbedingungen zu Oberflächendefekten wie Metallablösung neigt. Das Copolycarbonat aus Beispiel 1 erfüllt auch nicht die optischen Vorgaben (grau-intransparent). Das Material aus Beispiel 5 erfüllt zwar die Farbvorgaben, zeigt jedoch drastische Oberflächendefekte unter den gewählten Testbedingungen.

Dagegen erfüllen die erfindungsgemäßen Beispiele 2 und 3 die optischen Vorgaben und zeigen die gewünschte Oberflächenstabilität gegen thermische Beanspruchung. Überraschend war, dass den erfindungsgemäßen Zusammensetzungen ähnliche Rezepturen, d.h. mit ähnlichen Polymerzusmmensetzungen in der Basisschicht wie in Beispiel 5 gezeigt nicht zum gewünschten Resultat führen.

## Patentansprüche

1. Zusammensetzungen enthaltend
A) 60 Gew.-% bis 99 Gew.-% (bezogen auf die Summe der Gewichtsteile der Komponenten A+B) aus einem oder mehreren Copolycarbonaten mit einer Vicat-Erweichungstemperaturen von größer als 160 °C enthaltend als Kettenabbrecher (Endgruppe) eine Struktureinheit der Formel (1) 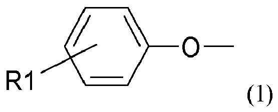 in der
R1 für Wasserstoff oder C₁-C₁₈-Alkyl stehen
und
mindestens ein Diphenolbaustein der Formel (2) enthält, 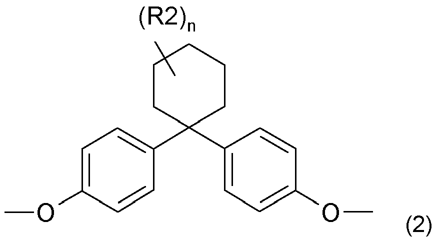 in der
R2 für C₁-C₄-Alkyl,
n für 0, 1, 2 oder 3,
und
B) 1 Gew.-% - 40 Gew.-% (bezogen auf die Summe der Gewichtsteile der Komponenten A+B) aus einem oder mehreren speziellen Polyarylsulfonen und / oder speziellen Polyetherimiden, welche die allgemeine Formel (I) , (II) oder (III) als Wiederholungseinheit aufweisen:
-O-A-SO₂-A- (I)
-O-A-SO₂-A-O-B- (II) 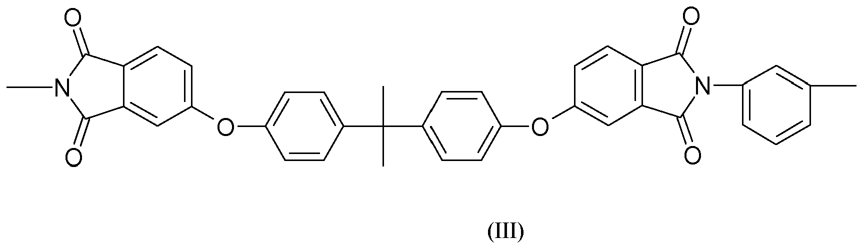
worin A und B für gegebenenfalls substituierte aromatische Reste stehen können, wobei die aromatischen Reste aus 6 bis 40 C-Atomen bestehen die einen oder mehrere gegebenenfalls kondensierte aromatische Kerne enthalten, wobei die Kerne gegebenenfalls Heteroatome enthalten können,
wobei alle Gewichtsteilangaben in der vorliegenden Anmeldung so normiert sind, dass die Summe der Gewichtsteile der Komponenten A+B in der Zusammensetzung 100 ergeben.

2. Zusammensetzung gemäß Anspruch 1, enthaltend ein hochwärmeformbeständiges Polycarbonat gemäß Komponente A), worin als Kettenabbrecher Phenol oder tert.-Butylphenol oder n-Butylphenol verwendet wird.

3. Zusammensetzung gemäß einem der Ansprüche 1 oder 2, enthaltend ein hochwärmeformbeständiges Polycarbonat gemäß Komponente A), worin R2 für Methyl-, Ethyl-, Propyl-, Isopropyl- und Butyl- sowie Isobutylreste, und n für 2 oder 3 stehen.

4. Zusammensetzung gemäß einem der Ansprüche 1 bis 3, **dadurch gekennzeichnet, dass** das hochwärmeformbeständiges Polycarbonat gemäß Komponente A) ein Copolycarbonat aus Bisphenol A und Bisphenol TMC ist.

5. Zusammensetzung gemäß einem der Ansprüche 1 bis 4, enthaltend 0 bis 1 Gew.-% (bezogen auf die Summe der Gewichtsteile der Komponenten A+B = 100), eines oder mehrerer Entformer (Komponente C).

6. Zusammensetzung gemäß einem der Ansprüche 1 bis 5, enthaltend 0 bis 0,2 Gew.-% (bezogen auf die Summe der Gewichtsteile der Komponenten A+B = 100), eines oder mehrerer Thermo- bzw. Verarbeitungsstabilisatoren (Komponente D).

7. Zusammensetzung gemäß einem der Ansprüche 1 bis 6, enthaltend 0 bis 0,05 Gew.-% (bezogen auf die Summe der Gewichtsteile der Komponenten A+B = 100), eines oder mehrerer Farbmittel (Komponente E).

8. Verwendung der Zusammensetzungen gemäß einem der Ansprüche 1 bis 7 zur Herstellung von Formkörpern.

9. Formkörper, enthaltend eine Zusammensetzung nach einem der Ansprüche 1 bis 7.

10. Formkörper aus einem hochwärmeformbeständiges Polycarbonat gemäß Anspruch 9, aufweisend eine Oberflächenbeschichtung aus einer Metallschicht.

11. Formkörper gemäß Anspruch 10, aufweisend eine Oberflächenbeschichtung aus einer Schicht aus wenigstens einem Metall und / oder wenigstens einer Metallverbindung mit einer Stärke von 10 - 1000 nm.

12. Formkörper gemäß Anspruch 11, aufweisend eine weitere Oberflächenbeschichtung bestehend aus plasmapolymerisierten Siloxanen der Dicke 5 nm - 200 nm.

13. Formkörper gemäß Anspruch 12, aufweisend eine weitere Oberflächenbeschichtung ...

14. Formkörper gemäß einem der Ansprüche 9 bis 13 **dadurch gekennzeichnet, dass** der Formkörper ein Teil eines Kraftfahrzeugs, Schienenfahrzeugs, Luftfahrzeugs oder Wasserfahrzeugs oder Folien, Profile oder Gehäuseteile jeder Art ist.

15. Mehrschichtiges Erzeugnis enthaltend eine Substratschicht, die mindestens auf einer Seite eine weitere Schicht aufweist, wobei die Substratschicht aus Zusammensetzungen nach einem der Ansprüche 1 bis 7 hergestellt wird.

16. Mehrschichtiges Erzeugnis nach Anspruch 15, **dadurch gekennzeichnet, dass** die Schicht auf der Substratschicht eine Metallschicht ist.

17. Mehrschichtiges Erzeugnis nach Anspruch 16, **dadurch gekennzeichnet, dass** auf der Metallschicht eine weitere Schutzschicht aufgetragen ist.

18. Verfahren zur Erzeugung eines mehrschichtiges Erzeugnisses nach einem der Ansprüche 15 bis 17, **dadurch gekennzeichnet, dass** die Schutzschicht in einem PECVD oder Plasmapolymerisationsprozess aufgebracht werden.

19. Verfahren zur Erzeugung von Mehrschichtiges Erzeugnis nach Anspruch 18, **dadurch gekennzeichnet, dass** die Schutzschicht durch PECVD oder Plasmapolymerisationsprozess von einer oder mehrerer leichtflüchtigen Komponenten ausgewählt aus Hexamethyldisiloxan (HMDSO), Tetrametyldisiloxan, Decamethylcyclopentasiloxan, Octamethylcyclotetrasiloxan und Trimethoximethylsilan erfolgt.
